# EUROPEAN PATENT SPECIFICATION

(11) **EP 3 860 328 B1**
(45) Date of publication and mention of the grant of the patent: **24.04.2024**
(21) Application number: 18935481.4
(22) Date of filing: 26.09.2018
(51) Int. Cl.: H05K 13/02, H05K 13/04

(54) **TAPE FEEDER**
BANDZUFÜHRER
DISPOSITIF D'ALIMENTATION EN BANDE

(43) Date of publication of application: 04.08.2021
(73) Proprietor: Fuji Corporation, Chiryu-shi, Aichi 472-8686 (JP)
(72) Inventor: YAMANAKA, Hidekazu, Chiryu-shi, Aichi 472-8686 (JP); YAMAZAKI, Atsushi, Chiryu-shi, Aichi 472-8686 (JP); HOSOI, Norio, Chiryu-shi, Aichi 472-8686 (JP); TANAKA, Keita, Chiryu-shi, Aichi 472-8686 (JP)
(74) Representative: Grünecker Patent- und Rechtsanwälte PartG mbB
(86) International application number: PCT/JP2018/035633
(87) International publication number: WO 2020/065754

(56) References cited:
- EP-A1- 2 869 682
- EP-A1- 3 349 557
- EP-A2- 0 967 849
- WO-A1-2011/089896
- WO-A1-2017/042898
- JP-A- H0 451 543
- JP-A- 2001 168 582
- JP-A- 2005 175 045
- JP-A- 2007 027 246
- JP-A- 2009 054 656
- JP-A- 2018 148 228
- US-A1- 2009 071 996
- US-A1- 2013 161 370

## Description

### Technical Field

The present specification discloses a technique relating to a tape feeder in which a sub plate is attached to a bottom face of a tape passage for feeding a component supply tape pulled out from a tape reel to a component pickup position.

### Background Art

The component supply tape to be set in the tape feeder accommodates components in component accommodating recessed sections formed on a carrier tape or the like at equal pitches, and is configured such that a top tape (top film) adheres on an upper face of the carrier tape. The tape feeder, with pitch-feeding being performed to the component supply tape fed toward the component pickup position, peels off the top tape right in front of the component pickup position, sequentially exposes and feeds the component in each component accommodating recessed section of the component supply tape to the component pickup position, and at that position, mounts the component on a circuit board by picking up the component with a suction nozzle of a component mounter.

During an operation of the tape feeder, the component in the component accommodating recessed section of the component supply tape is likely to positionally deviate, slant, or jump out due to vibration and shock, which may be caused by a pitch-feeding operation of the component supply tape or by peeling the top tape, or static electricity, and this causes abnormal pickup such as component pickup error (pickup failure) or oblique pickup of the suction nozzle.

As a countermeasure, as described in Patent Literature 1 (JP-A-2007-27246), there is a method that by attaching a sub plate (support plate) with a magnet to a bottom face portion of a tape passage of a tape feeder, a component is attracted to the bottom face side of a component accommodating recessed section of a component supply tape by a magnetic attraction force of the magnet, and then the component in the component accommodating recessed section is prevented from positionally deviating, slanting, or jumping out. Patent Literature 2 (EP 2 869 682 A1), Patent Literature 3 (EP 3 349 557 A1) and Patent Literature 4 (JP 2005 175045 A) each disclose tape feeders according to the preamble of claim 1. Patent Literature 5 (JP 2018 148228 A) discloses a component mounting method wherein individual exposure mechanism identification information of a component exposure mechanism, which is mounted on a tape feeder and exposes a component with a cover tape peeled therefrom by a peeling member, is detected by imaging an identification mark formed on the component exposure mechanism with a substrate recognition camera. Then, whether or not the component exposure mechanism mounted on the tape feeder is compatible with an object component set thereon by checking the detected individual exposure mechanism identification information against the individual exposure mechanism identification information of the appropriate component exposure mechanism preliminarily allocated thereto in association with the component.

### Patent Literature

Patent Literature 1: JP-A-2007-27246
Patent Literature 2: EP 2 869 682 A1
Patent Literature 3: EP 3 349 557 A1
Patent Literature 4: JP 2005 175045 A
Patent Literature 5: JP 2018 148228 A

### Summary of the Invention

### Technical Problem

Depending on a type of the component of the component supply tape, although there are some components that have no problem with magnetic action, but there are also some components that are vulnerable to magnetism, and some components that have no problem with weak magnetism, but need to be avoided from strong magnetism. Therefore, it is desirable that the sub plate to be attached to the bottom face of the tape passage of the tape feeder can also be exchanged with a sub plate having a different magnetic strength, depending on the type of the component of the component supply tape to be used. In a case where the sub plate cannot be exchanged, it is necessary to be exchanged with a tape feeder to which a sub plate having different magnetic strength is attached, depending on the type of parts of the component supply tape to be used.

Therefore, an operator needs to check whether the type of the sub plate attached to the tape feeder is suitable for the type of the component of the component supply tape, when setting the component supply tape to the tape feeder.

However, since the sub plate attached to the bottom face of the tape passage inside the tape feeder is hidden inside the tape feeder and cannot be visually recognized, a human error that the operator sets the component supply tape in the tape feeder without noticing a wrong type of sub plate may occur. As a result, a production is started with the wrong type of sub plate, so that the abnormal pickup such as component pickup error or oblique pickup by the suction nozzle may occur, or a component vulnerable to magnetism may be damaged by magnetism of the sub plate.

### Solution to Problem

The above problem is solved by the features of claim 1.

With this configuration, when the operator checks the type of the sub plate attached to the bottom face of the tape passage inside the feeder main body, since the type display section of the sub plate can be seen from the viewing window section of the feeder main body, the operator can easily visually recognize the type of the sub plate.

### Brief Description of Drawings

[Fig. 1] Fig. 1 is a perspective view of a tape feeder of an embodiment.
[Fig. 2] Fig. 2 is a perspective view showing a tape passage and a peripheral portion thereof of the tape feeder.
[Fig. 3] Fig. 3 is a side view showing the tape passage and the peripheral portion thereof of the tape feeder.
[Fig. 4] Fig. 4 is a side view showing a viewing window section and a peripheral portion thereof of a feeder main body.
[Fig. 5] Fig. 5 is an enlarged side view of a sub plate.
[Fig. 6] Fig. 6 is a block diagram showing a configuration of a control system of the tape feeder.
[Fig. 7] Fig. 7 is a longitudinal section front view showing an enlarged holding structure at an upper end face portion side of the tape feeder set in a feeder setting section of a component mounter.
[Fig. 8] Fig. 8 is a partially cutaway side view showing an enlarged clamping structure at the upper end face portion side of the tape feeder set in the feeder setting section of the component mounter.

### Description of Embodiments

Hereinafter, an embodiment disclosed in the present specification will be described using drawings.

First, an entire configuration of tape feeder 10 will be described.

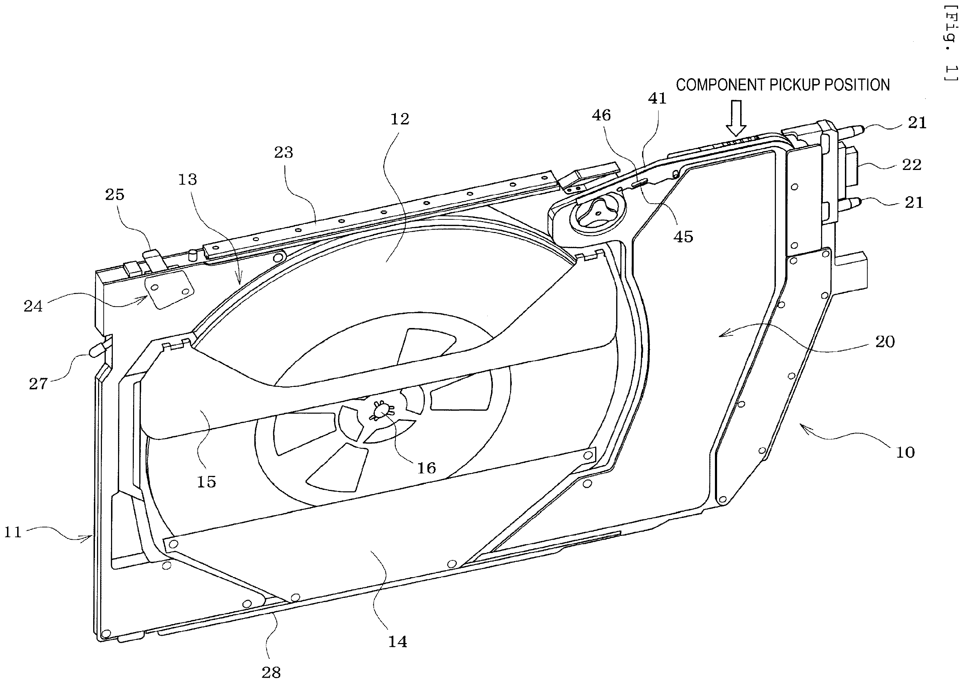

As shown in Fig. 1, in thin case-shaped feeder main body 11 of tape feeder 10, reel accommodation space 13 that exchangeably (attachably and detachably) accommodates tape reel 12 on which a component supply tape (not shown) is wound is provided. At a lower portion of reel accommodation space 13, lower side reel cover 14 that covers a lower portion of tape reel 12 accommodated in reel accommodation space 13 is provided. At an upper portion of reel accommodation space 13, upper side reel cover 15 that covers an upper portion of tape reel 12 accommodated in reel accommodation space 13 is provided so as to be opened and closed turnably with both sides of an upper end portion thereof as fulcrums.

In a case of taking out tape reel 12 from reel accommodation space 13, upper side reel cover 15 is turned upward with both sides of the upper end portion thereof as the fulcrums to open an upper side of reel accommodation space 13 and to allow the hand to grip an upper side of tape reel 12 in reel accommodation space 13 and pull out tape reel 12 obliquely upward while slightly tilting it outward. On the other hand, in a case of setting tape reel 12 in reel accommodation space 13, tape reel 12 is inserted from obliquely above into reel accommodation space 13 in which upper side reel cover 15 is opened such that the lower side of tape reel 12 is inserted into the inside of lower side reel cover 14 and upper side reel cover 15 is closed, so that setting tape reel 12 in reel accommodation space 13 is completed.

In this case, a configuration may be adopted in which a short reel holding shaft (not shown) that is fitted into center hole 16 of tape reel 12 is provided in the central part of reel accommodation space 13, such that tape reel 12 is rotatably supported by the short reel holding shaft. In a case where the configuration is adopted, in order to prevent the reel holding shaft, which is fitted into center hole 16 of tape reel 12, from hindering the attachability and detachability of tape reel 12, the length of the reel holding shaft is preferably set to be shorter than the length of center hole 16 of tape reel 12 (for example, set to 1/2 to 1 /3 of the length). Alternatively, a configuration may be adopted in which multiple rollers (not shown) are provided at a lower side of reel accommodation space 13 along an outer circumference of tape reel 12 such that the outer circumference of tape reel 12 is rotatably borne and supported by the multiple rollers.

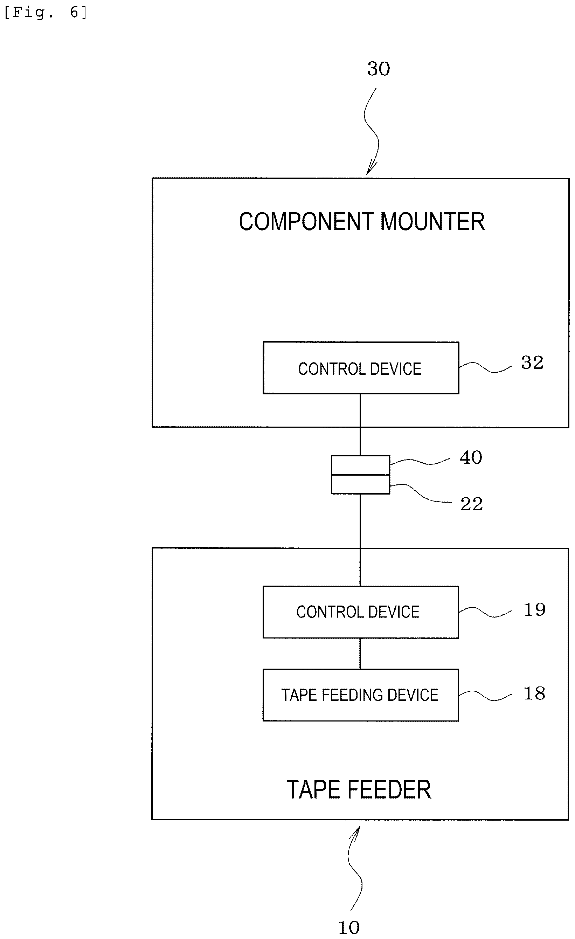

A component pickup position where a component is picked up with a suction nozzle (not shown) of component mounter 30 (see Fig. 6) is set at a position near an end face portion of an upper end face portion of feeder main body 11 on feeder main body 11 attachment direction side.

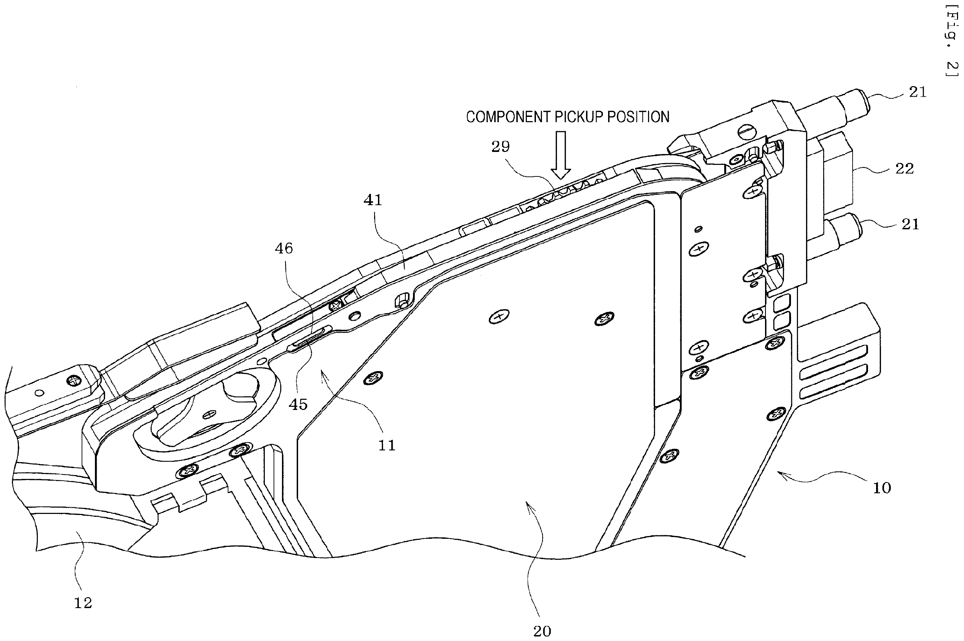

In feeder main body 11, a space between reel accommodation space 13 and the end face portion on feeder main body 11 attachment direction side serves as electrical equipment accommodation space 20. Electrical equipment accommodation space 20 is provided with various electrical equipment such as tape feeding device 18 (see Fig. 6) that pulls out the component supply tape from tape reel 12 in reel accommodation space 13 and pitch-feeds the component supply tape to the component pickup position and control device 19 (see Fig. 6) that controls a pitch-feeding operation. Tape feeding device 18 rotates and drives sprocket 29 (see Fig. 2) using a motor (not shown) such as a servomotor or stepping motor as a driving source, sprocket is intermittently rotated by a predetermined rotation angle by meshing teeth of sprocket 29 with feeding holes of the component supply tape, such that the component supply tape is pulled out from tape reel 12 by one pitch and pitch-fed to the component pickup position.

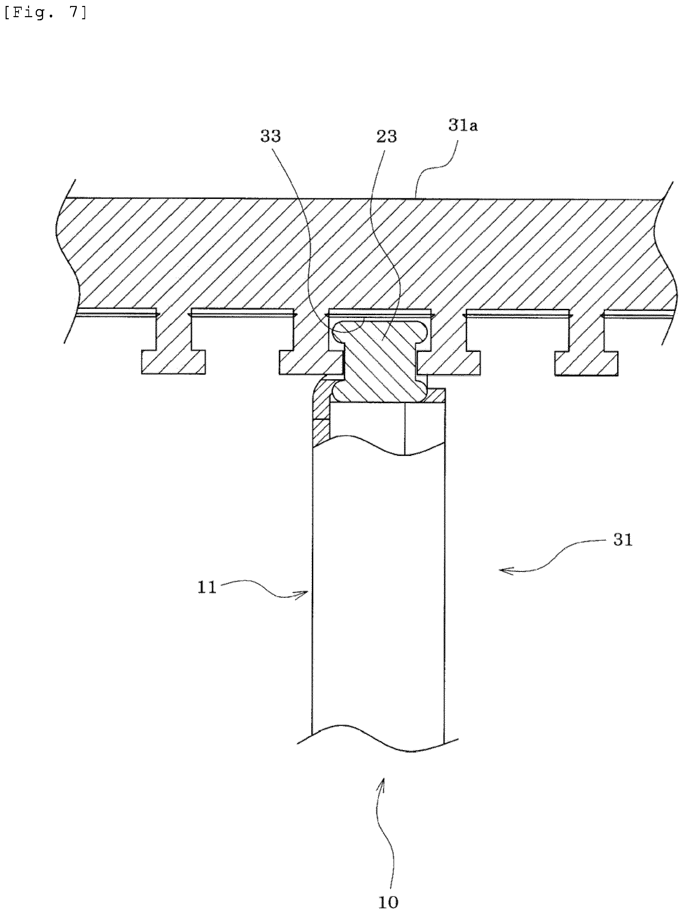

Two positioning pins 21, 21 (positioning portions) that perform positioning with respect to feeder setting section 31 (see Fig. 7) of component mounter 30 are provided at a predetermined interval in a vertical direction at positions higher than the center in a height direction of the end face portion on feeder main body 11 attachment direction side (in the present embodiment, positions near the upper end face portion of feeder main body 11). Connector 22 for both power supply and communication is provided between two positioning pins 21, 21 and, by inserting and connecting connector 22 of feeder main body 11 to connector 40 of component mounter 30 side (see Fig. 6), power is supplied, from component mounter 30 side, to various electrical equipment such as tape feeding device 18 or control device 19 in feeder main body 11 and various signals such as control signals or sensor signals are transmitted and received between control device 32 of component mounter 30 (see Fig. 6) and control device 19 of feeder main body 11.

Next, a configuration in which feeder main body 11 is held in a set state (attached state) with respect to feeder setting section 31 of component mounter 30 will be described.

On the upper end face portion of feeder main body 11, guide rail 23 having a T-shaped cross section is provided, as an upper holding member, so as to extend in an attachment and detachment direction of feeder main body 11. Correspondingly, as shown in Fig. 7, in member 31a of an upper side of feeder setting section 31 of component mounter 30, slot groove 33 having a T-shaped cross section into which guide rail 23 having a T-shaped cross section of feeder main body 11 is fitted in a slidably movable manner in the attachment and detachment direction of feeder main body 11 is provided so as to extend in the attachment and detachment direction of feeder main body 11. Thus, guide rail 23 having a T-shaped cross section of feeder main body 11 is fitted into slot groove 33 having a T-shaped cross section of feeder setting section 31, so that slide movement of feeder main body 11 in the attachment and detachment direction is guided and feeder main body 11 is held in a state where being pulled out downward is prevented. In member 31a of the upper side of feeder setting section 31, multiple slot grooves 33 are provided at predetermined intervals such that multiple feeder main body 11 can be set in feeder setting section 31.

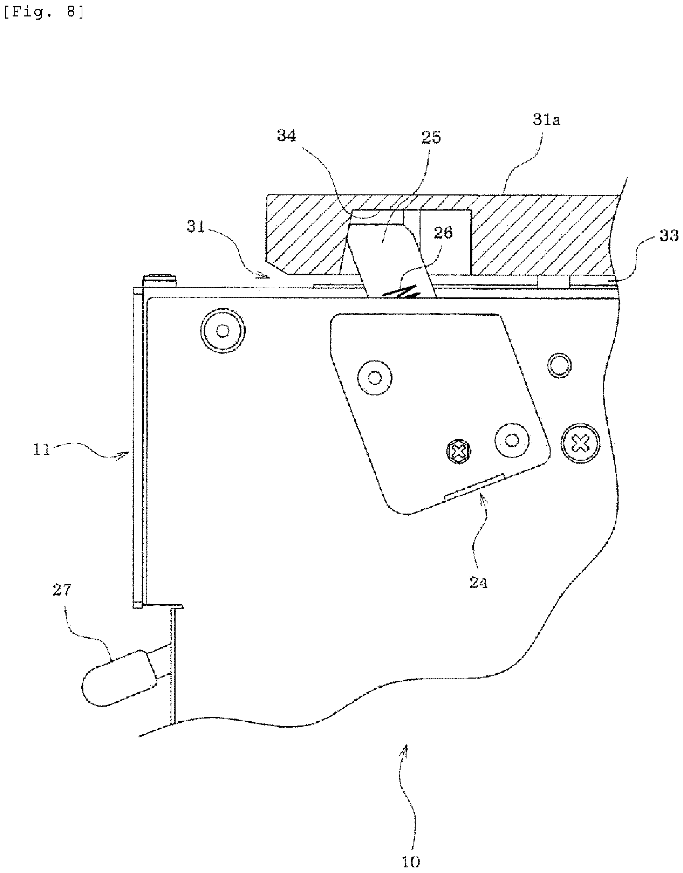

In addition, clamping device 24 (see Fig. 8) that clamps feeder main body 11 in the attached state with respect to feeder setting section 31 of component mounter 30 is provided at a position near an end face portion of the upper end face portion of feeder main body 11 on feeder main body 11 detachment direction side. Clamping device 24 includes clamping member 25 that protrudes obliquely upward from the upper end face portion of feeder main body 11 during a clamp operation, spring 26 that biases clamping member 25 obliquely upward, which is a clamp direction, and operation lever 27 (operation section) that operates a clamp release operation to retract clamping member 25 obliquely downward, which is a clamp release direction. Operation lever 27 is disposed so as to protrude from the end face portion on feeder main body 11 detachment direction side.

Meanwhile, clamp hole 34 (see Fig. 8) is provided at a position corresponding to clamping member 25, of member 31a of the upper side of feeder setting section 31 of component mounter 30 such that, by fitting clamping member 25 into clamp hole 34, feeder main body 11 is clamped in the attached state. In this case, as shown in Fig. 8, by pushing clamping member 25 obliquely upward on feeder main body 11 detachment direction side with spring 26, an upper end portion of clamping member 25 is pressed against a side face of clamp hole 34 on feeder main body 11 detachment direction side, and due to the reaction, feeder main body 11 is pressed toward the attachment direction side, so that feeder main body 11 is positioned with high accuracy, and the connected state between connectors 22 and 40 is held.

As shown in Fig. 1, in a lower end face portion of feeder main body 11, guide rail 28 having an l-shaped cross section is provided, as a lower holding member, so as to extend in the attachment and detachment direction of feeder main body 11. Correspondingly, in a member (not shown) of a lower side of feeder setting section 31 of component mounter 30, a rail groove (not shown) having an I-shaped cross section into which guide rail 28 having an l-shaped cross section of feeder main body 11 is fitted in a slidably movable manner in the attachment and detachment direction of feeder main body 11 is provided, and by fitting guide rail 28 having an I-shaped cross section of feeder main body 11 into the rail groove having an I-shaped cross section of feeder setting section 31, slide movement of feeder main body 11 in the attachment and detachment direction is guided and feeder main body 11 is held in a state where pulling out upward is not prevented. In this manner, even when manufacturing variation in height dimension of feeder setting section 31 of component mounter 30 or manufacturing variation in height dimension of feeder main body 11 is increased to some extent, the friction resistance can be prevented from increasing during the slide movement of feeder main body 11 in the attachment and detachment direction, and feeder main body 11 can be smoothly attached and detached.

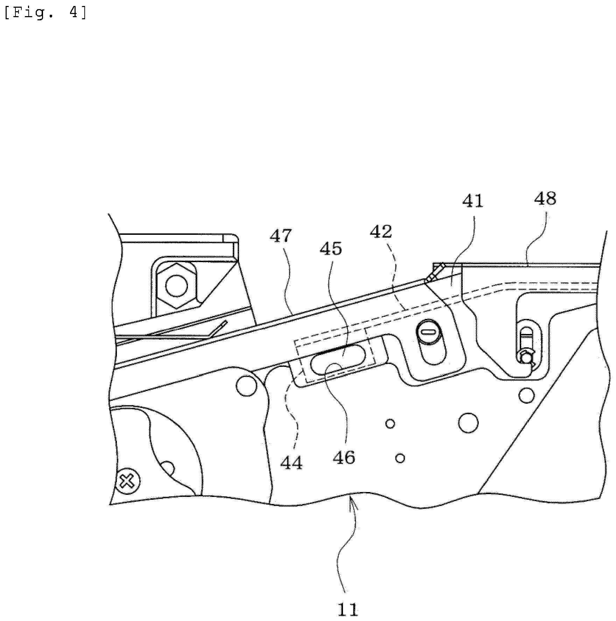

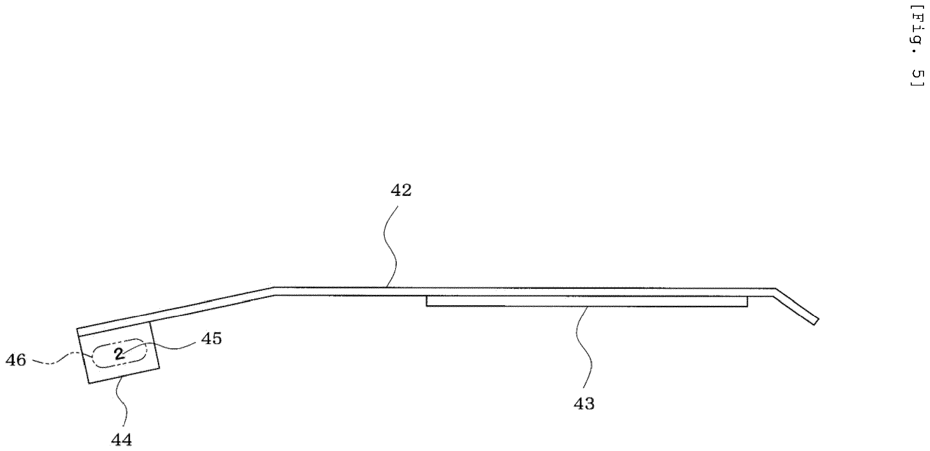

At a bottom face of tape passage 41 for pitch-feeding the component supply tape pulled out from tape reel 12 to the component pickup position, sub plate 42 (see Figs. 4 and 5) is exchangeably attached by screwing, engagement, or the like. Types of sub plate 42 that can be attached to the bottom face of tape passage 41 are classified depending on at least one of a magnetic property of the component supply tape for the component (for example, presence or absence of a magnetic attraction force or magnitude of a magnetic attraction force) or a material (for example, magnetic metal such as iron, non-magnetic metal such as aluminum, or resin) of sub plates 42. Sub plate 42 selected from multiple types of sub plates 42 is attached to the bottom face of tape passage 41.

To an under face of sub plate 42 shown in Fig. 5, plate-shaped magnet 43 is fixed by adhesion or the like so as to stabilize the orientation of the component during pitch-feeding by acting a magnetic attraction force to the component of the component supply tape. Projecting piece portion 44 is provided at a predetermined position of sub plate 42 so as to hang down and type display section 45 that indicates the type of sub plate 42 by any of a character, a symbol, a pattern, and a color is provided on a surface of projecting piece portion 44. Type display section 45 is formed by any of printing such as stamping, inkjet, coating, seal attachment, or the like.

Meanwhile, viewing window section 46 that allows the operator to visually recognize type display section 45 from outside feeder main body 11 is formed at a position of feeder main body 11 that corresponds to type display section 45.

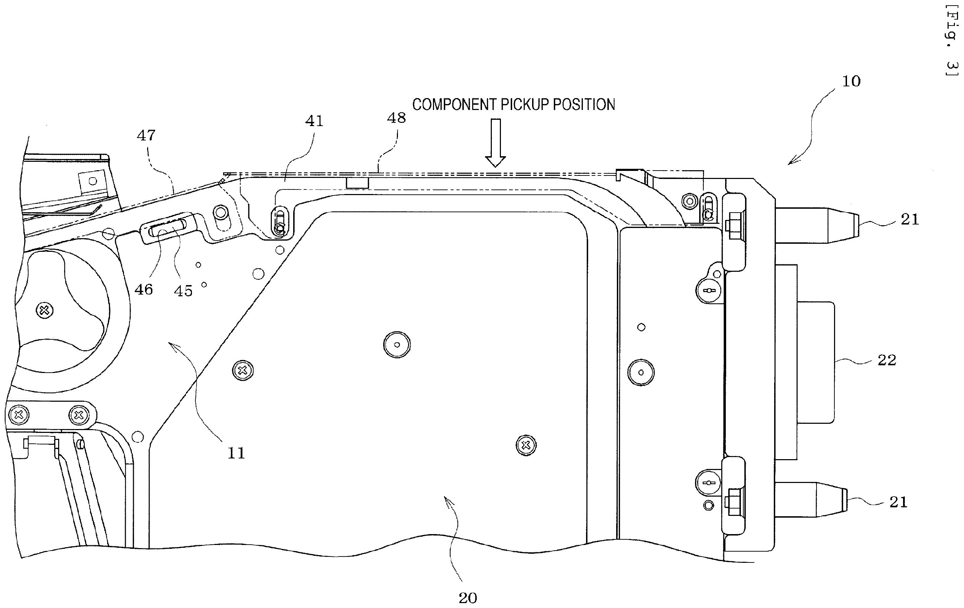

Further, an upper face side of tape passage 41 is covered by tape holding covers 47 and 48 that hold the component supply tape passing through tape passage 41, from above (see Figs. 3 and 4). In Figs. 1 and 2, tape passage 41 is shown in a state where tape holding covers 47 and 48 are removed.

According to the present embodiment described above, since sub plate 42 is provided with type display section 45 that shows the type of sub plate 42, and viewing window section 46, allowing the operator to visually recognize type display section 45 from outside feeder main body 11, is formed at the position of feeder main body 11, the positon of which being corresponds to type display section 45, when the operator checks the type of sub plate 42 attached to the bottom face of tape passage 41 inside feeder main body 11, type display section 45 of sub plate 42 can be seen from viewing window section 46 of feeder main body 11, so that the operator can easily visually recognize the type of sub plate 42. In this manner, it is possible to prevent a human error that the operator sets the component supply tape in tape feeder 10 without noticing a wrong type of sub plate 42.

Further, in the present embodiment, feeder main body 11 accommodates tape reel 12 therein, but a reel holder may be provided outside the feeder main body and the tape reel is accommodated in the reel holder.

### Reference Signs List

10... Tape feeder, 11... feeder main body, 12... tape reel, 13... reel accommodation space, 14... lower side reel cover, 15... upper side reel cover, 18... tape feeding device, 30... component mounter, 31... feeder setting section, 41... tape passage, 42... sub plate, 43... magnet, 45... type display section, 46... viewing window section, 47, 48... tape holding cover

## Claims

1. A tape feeder (10) comprising:
a sub plate (42) configured to be attached to a bottom face of a tape passage (41) for feeding a component supply tape pulled out from a tape reel (12) to a component pickup position and be disposed inside a feeder main body (11),
**characterized in that**
the sub plate (42) is provided with a type display section (45) that is configured to show the type of the sub plate (42), and
the feeder main body (11) is provided with a viewing window section (46) in a position corresponding to the type display section (45) of the sub plate (42) such, that the viewing window section (46) is enabling an operator to visually recognize the type display section (45) from outside the feeder main body (11) through the viewing window section (46).

2. The tape feeder (10) according to claim 1,
wherein the types of the sub plates (42) are classified depending on at least one of a magnetic property of the component supply tape for a component or a material of the sub plate (42).

3. The tape feeder (10) according to claim 1 or 2,
wherein the type display section (45) indicated by any of a character, a symbol, a pattern, and a color.

4. The tape feeder (10) according to any one of claims 1 to 3, wherein the sub plate (42) is selected from multiple types of sub plates (42) and is attached to the bottom face of the tape passage (41).

5. The tape feeder (10) according to any one of claims 1 to 4,
wherein the feeder main body (11) is formed in a thin case shape, and
the tape reel (12) is accommodated inside the feeder main body (11).

## Patentansprüche

1. Ein Bandzuführer (10) umfassend:
eine Unterplatte (42), die konfiguriert ist, an einer Bodenfläche eines Banddurchgangs (41) zum Zuführen eines von einer Bandspule (12) herausgezogenen Bauteilzuführbandes zu einer Bauteilaufnahmeposition angebracht zu werden und innerhalb eines Zuführerhauptkörpers (11) angeordnet zu sein,
**gekennzeichnet dadurch, dass**
die Unterplatte (42) mit einem Typenanzeigeabschnitt (45) versehen ist, der konfiguriert ist, den Typ der Unterplatte (42) anzuzeigen, und
der Zuführerhauptkörper (11) mit einem Sichtfensterabschnitt (46) in einer Position versehen ist, die dem Typenanzeigeabschnitt (45) der Unterplatte (42) entspricht, so dass der Sichtfensterabschnitt (46) es einem Bediener ermöglicht, den Typenanzeigeabschnitt (45) von außerhalb des Zuführerhauptkörpers (11) durch den Sichtfensterabschnitt (46) visuell zu erkennen.

2. Der Bandzuführer (10) gemäß Anspruch 1, wobei
die Typen der Unterplatten (42) in Abhängigkeit von mindestens einer magnetischen Eigenschaft des Bauteilzuführbandes für ein Bauteil oder einem Material der Unterplatte (42) klassifiziert werden.

3. Der Bandzuführer (10) gemäß Anspruch 1 oder 2, wobei
der Typanzeigeabschnitt (45), durch ein Zeichen, ein Symbol, ein Muster oder eine Farbe angezeigt wird.

4. Der Bandzuführer (10) gemäß einem der Ansprüche 1 bis 3, wobei
die Unterplatte (42) aus mehreren Typen von Unterplatten (42) ausgewählt und an der Unterseite des Banddurchgangs (41) befestigt wird.

5. Der Bandzuführer (10) gemäß einem der Ansprüche 1 bis 4, wobei
der Zuführerhauptkörper (11) in einer dünnen Gehäuseform ausgebildet ist, und
die Bandspule (12) im Inneren des Zuführerhauptkörpers (11) untergebracht ist.

## Revendications

1. Dispositif d'alimentation de bande (10) comprenant :
une sous-plaque (42) configurée pour être attachée à une face de fond d'un passage de bande (41) pour alimenter une bande d'approvisionnement en composants tirée d'une bobine de bande (12) jusqu'à une position de saisie de composant et pour être disposée à l'intérieur d'un corps principal de dispositif d'alimentation (11),
**caractérisé en ce que**
la sous-plaque (42) est pourvue d'une section d'affichage de type (45) qui est configurée pour montrer le type de la sous-plaque (42), et
le corps principal de dispositif d'alimentation (11) est pourvu d'une section de fenêtre de visualisation (46) à une position correspondant à la section d'affichage de type (45) de la sous-plaque (42), de telle sorte que la section de fenêtre de visualisation (46) permet à un opérateur de reconnaître visuellement la section d'affichage de type (45) depuis l'extérieur du corps principal de dispositif d'alimentation (11) à travers la section de fenêtre de visualisation (46).

2. Dispositif d'alimentation de bande (10) selon la revendication 1,
dans lequel les types des sous-plaques (42) sont classés en fonction d'au moins une caractéristique parmi une propriété magnétique de la bande d'approvisionnement en composants pour un composant et un matériau de la sous-plaque (42).

3. Dispositif d'alimentation de bande (10) selon la revendication 1 ou 2,
dans lequel la section d'affichage de type (45) est indiquée par une caractéristique quelconque parmi un caractère, un symbole, un motif et une couleur.

4. Dispositif d'alimentation de bande (10) selon l'une quelconque des revendications 1 à 3, dans lequel la sous-plaque (42) est sélectionnée parmi de multiples types de sous-plaques (42) et est attachée à la face de fond du passage de bande (41).

5. Dispositif d'alimentation de bande (10) selon l'une quelconque des revendications 1 à 4,
dans lequel le corps principal de dispositif d'alimentation (11) est conformé comme un boîtier mince, et
la bobine de bande (12) est logée à l'intérieur du corps principal de dispositif d'alimentation (11).
